(19) Europäisches Patentamt
European Patent Office
Office européen des brevets

(11) **EP 3 211 982 B1**

(12) **EUROPEAN PATENT SPECIFICATION**

(45) Date of publication and mention
of the grant of the patent:
**30.09.2020 Bulletin 2020/40**

(51) Int Cl.:
***H05K 9/00*** *(2006.01)*

(21) Application number: **16182393.5**

(22) Date of filing: **02.08.2016**

(54) **NEAR-FIELD ELECTROMAGNETIC WAVE ABSORBING FILM**

ABSORBIERENDE FOLIE FÜR ELEKTROMAGNETISCHE NAHFELDWELLEN

FILM D'ABSORPTION D'ONDES ELECTROMAGNETIQUES A CHAMP PROCHE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.02.2016 JP 2016036465**

(43) Date of publication of application:
**30.08.2017 Bulletin 2017/35**

(73) Proprietor: **Kagawa, Seiji**
**Saitama 343-0807 (JP)**

(72) Inventor: **Kagawa, Seiji**
**Saitama 343-0807 (JP)**

(74) Representative: **SSM Sandmair**
**Patentanwälte Rechtsanwalt**
**Partnerschaft mbB**
**Joseph-Wild-Straße 20**
**81829 München (DE)**

(56) References cited:
**EP-A1- 1 993 338      WO-A1-2014/148589**
**WO-A2-2011/017037   US-A1- 2014 098 501**
**US-A1- 2014 224 411**

**Description**

FIELD OF THE INVENTION

The present invention relates to a near-field electromagnetic wave absorbing film having high electromagnetic wave absorbability.

BACKGROUND OF THE INVENTION

Electromagnetic wave absorbing sheets for preventing the leakage and intrusion of electromagnetic waves are used for communications apparatus such as mobile phones, smartphones, wireless LANs, etc., and electronic appliances such as computers, etc. Electromagnetic wave absorbing sheets widely used at present are constituted by sheets or nets of metals, and electromagnetic wave absorbing sheets having metal films vapour-deposited on plastic sheets have recently been proposed. For example, JP 9-148782 A proposes an electromagnetic wave absorbing sheet comprising a plastic film, and first and second aluminium films vapour-deposited on both surfaces of the plastic film, the first vapour-deposited aluminium film being etched in a non-conductive linear pattern, and the second vapour-deposited aluminium film being etched in a conductive network pattern.

WO 2010/093027 discloses a composite film comprising a plastic film, and a single- or multi-layered thin metal film formed on at least one surface of the plastic film, the thin metal film being provided with large numbers of substantially parallel, intermittent linear scratches with irregular widths and intervals in plural directions, thereby having reduced anisotropy of electromagnetic wave absorbability.

In the electromagnetic wave absorbing sheet of JP 9-148782 A and the composite film of WO 2010/093027 having a linearly scratched thin metal film and a plastic film, electromagnetic wave absorbability is obtained by linear patterns or scratches. Apart from this, it is also desired to efficiently form an electromagnetic wave absorbing film having excellent electromagnetic wave absorbability by laser beam spot patterns.

EP 1 993 338 A1 describes a process for preparing a light-transmissive electromagnetic shielding material, comprising: coating a transparent substrate with a pre-treatment agent for electroless plating to form a coated layer; drying the coated layer to provide a pre-treatment layer on the transparent substrate; forming a plating protective layer in the dot pattern on the pre-treatment layer; and subjecting the exposing part of the pre-treatment layer having no plating protective layer to electroless plating to form a metal conductive layer in the mesh pattern.

WO 2014/148589 A1 describes an electromagnetic shield in which an intermediate layer is formed on a glass substrate and an electroconductive layer of aluminium is formed on the intermediate layer, wherein the electromagnetic shield is characterised in that after the intermediate layer and the electroconductive layer are formed by sputtering or vacuum deposition, openings are formed by wet etching.

OBJECT OF THE INVENTION

Accordingly, an object of the present invention is to provide a near-field electromagnetic wave absorbing film having laser-etched openings formed in a thin metal film for good electromagnetic wave absorbability with reduced anisotropy.

SUMMARY OF THE INVENTION

The invention is as set out in claim 1.

As a result of intensive research in view of the above object, the inventor has found that (a) the formation of plural lines of laser-etched openings in two directions on a thin metal film formed on a plastic film, such that at least part of adjacent laser-etched openings are separated, provides a near-field electromagnetic wave absorbing film having excellent electromagnetic wave absorbability with small anisotropy. The present invention has been completed based on this finding.

Thus, the near-field electromagnetic wave absorbing film of the present invention comprises a plastic film, and a single- or multi-layered thin metal film formed on a surface of the plastic film, wherein: the thin metal film is provided with plural lines of openings extending and crossing in two directions; pluralities of the openings are arranged in each line such that at least part of adjacent openings are separated; the opening lines extend in two directions crossing at an angle of 45 to 90°; thin metal film portions remaining after forming the openings are composed of wide remaining portions partitioned by the opening lines, and bridge-like remaining portions connecting adjacent wide remaining portions; and the bridge-like remaining portions have widths of 20 $\mu$m or less; wherein the openings are laser-etched and the near-field electromagnetic wave absorbing film has an electrical resistance of 50 to 300 $\Omega$/100 cm$^2$ and a light transmittance, measured with laser rays having a wavelength of 660 nm, of 30 to 80%.

The bridge-like remaining portions preferably have an average width of 2 to 15 $\mu$m.

The crossing angle of the laser-etched opening lines is preferably 60-90°.

The laser-etched openings preferably have diameters of 100 $\mu$m or less.

The centreline distance between adjacent laser-etched opening lines is preferably 1.5 to 5 times the diameters of the laser-etched openings.

The thickness of the thin metal film is preferably 10 to 300 nm.

The thin metal film is preferably made of at least one metal selected from the group consisting of aluminium, copper, silver, tin, nickel, cobalt, chromium and alloys thereof.

BRIEF DESCRIPTION OF THE DRAWINGS

Figure 1 is a partial enlarged plan view showing a near-field electromagnetic wave absorbing film according to one embodiment of the present invention.

Figure 2(a) is a cross-sectional view taken along the line A-A in Figure 1.

Figure 2(b) is a cross-sectional view taken along the line B-B in Figure 1.

Figure 3 is a partial enlarged view of Figure 1.

Figure 4 is a partial enlarged plan view showing a near-field electromagnetic wave absorbing film according to another embodiment of the present invention.

Figure 5 is a partial enlarged view of Figure 4.

Figure 6(a) is a perspective view showing an apparatus for measuring the electrical resistance of a near-field electromagnetic wave absorbing film.

Figure 6(b) is a plan view showing the measurement of the electrical resistance of a near-field electromagnetic wave absorbing film using the apparatus of Figure 6(a).

Figure 6(c) is a cross-sectional view taken along the line C-C in Figure 6(b).

Figure 7(a) is a plan view showing a system for evaluating the electromagnetic wave absorbability of a near-field electromagnetic wave absorbing film.

Figure 7(b) is a partially cross-sectional front view showing a system for evaluating the electromagnetic wave absorbability of a near-field electromagnetic wave absorbing film.

Figure 8 is a photomicrograph showing the near-field electromagnetic wave absorbing film of Example 1.

Figure 9 is a photomicrograph showing the near-field electromagnetic wave absorbing film of Comparative Example 1.

Figure 10 is a photomicrograph showing the near-field electromagnetic wave absorbing film of Comparative Example 2.

Figure 11 is a graph showing the relations between $S_{11}$ and the frequency of incident electromagnetic waves in the near-field electromagnetic wave absorbing films of Example 1 and Comparative Examples 1 and 2.

Figure 12 is a graph showing the relations between a transmission attenuation power ratio Rtp and the frequency of incident electromagnetic waves in the near-field electromagnetic wave absorbing films of Example 1 and Comparative Examples 1 and 2.

Figure 13 is a photomicrograph showing the near-field electromagnetic wave absorbing film of Example 2.

Figure 14 is a photomicrograph showing the near-field electromagnetic wave absorbing film of Comparative Example 3.

Figure 15 is a photomicrograph showing the near-field electromagnetic wave absorbing film of Comparative Example 4.

Figure 16 is a graph showing the relations between $S_{11}$ and the frequency of incident electromagnetic waves in the near-field electromagnetic wave absorbing films of Example 2 and Comparative Examples 3 and 4.

Figure 17 is a graph showing the relations between a transmission attenuation power ratio Rtp and the frequency of incident electromagnetic waves in the near-field electromagnetic wave absorbing films of Example 2 and Comparative Examples 3 and 4.

Figure 18 is a graph showing the relation between a noise absorption ratio $P_{loss}/P_{in}$ and the frequency of incident electromagnetic waves in the near-field electromagnetic wave absorbing film of Example 2.

DESCRIPTION OF THE PREFERRED EMBODIMENTS

The embodiments of the present invention will be explained in detail by referring to the attached drawings, and it should be noted that explanations concerning one embodiment may be applicable to other embodiments unless otherwise mentioned. Also, the following explanation is not restrictive, and various modifications may be made within the scope of the present invention.

[1] Near-field electromagnetic wave absorbing film

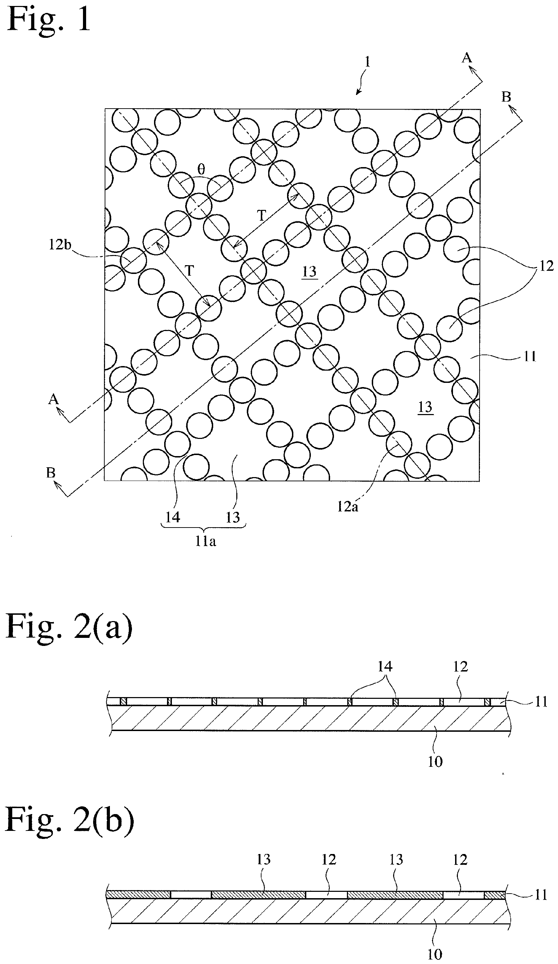

Figures 1 and 2 show a near-field electromagnetic wave absorbing film 1 according to a preferred embodiment of the present invention. This near-field electromagnetic wave absorbing film 1 comprises a single- or multi-layered thin metal film 11 formed on a surface of a plastic film 10, the thin metal film 11 being provided with plural lines of laser-etched openings 12 extending and crossing in two directions.

(1) Plastic film

Resins forming the plastic film 10 are not particularly restrictive as long as they have sufficient strength, flexibility and workability in addition to insulation, and they may be, for instance, polyesters (polyethylene terephthalate, etc.), polyarylene sulphide (polyphenylene sulphide, etc.), polyamides, polyimides, polyamide-imides, polyether sulphone, polyetheretherketone, polycarbonates, acrylic resins, polystyrenes, polyolefins (polyethylene, polypropylene, etc.), etc. From the aspect of strength and cost, polyethylene terephthalate (PET) is preferable. The thickness of the plastic film 10 may be about 10 to 100 $\mu$m.

(2) Thin metal film

Though not limited as long as they are conductive, metals forming the thin metal film 11 are preferably aluminium, copper, silver, tin, nickel, cobalt, chromium and alloys thereof, particularly aluminium, copper, nickel and their alloys, from the aspect of corrosion resistance and cost. The thickness of the thin metal film is preferably 10 to 300 nm, more preferably 20 to 200 nm, most preferably 30 to 150 nm. The thin metal film 11 can be formed by vapour deposition (physical vapour deposition such as vacuum vapour deposition, sputtering, ion plating, etc.; or chemical vapour deposition such as plasma CVD, thermal CVD, photo-CVD, etc.), plating, or foil-bonding.

When the thin metal film 11 has a single layer, the thin metal film 11 is preferably made of aluminium or nickel, from the aspect of conductivity, corrosion resistance and cost. When the thin metal film 11 has pluralities of layers, one may be made of a non-magnetic metal, and the other may be made of a magnetic metal. The non-magnetic metal may be aluminium, copper, silver, tin or an alloy thereof, and the magnetic metal may be nickel, cobalt, chromium or an alloy thereof. As long as their total thickness is within the above range, the non-magnetic metal layer and the magnetic metal layer are not restricted in thickness.

(3) Laser-etched opening lines

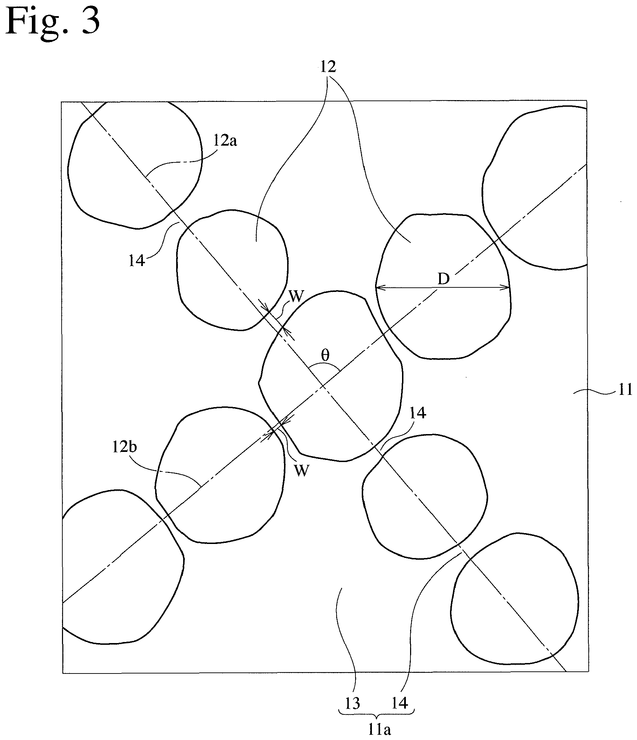

As shown in Figures 1 to 3, each laser-etched opening 12 is a substantially circular opening formed by evaporating a metal by irradiating the thin metal film 11 with laser beam spots, without boring the plastic film 10. The diameter D of each laser-etched opening 12 is preferably 100 $\mu$m or less, more preferably 40 to 80 $\mu$m.

Plural lines of laser-etched openings 12 are arranged in the thin metal film 11, such that they extend and cross in two directions. The thin metal film 11 is partitioned by crossing laser-etched opening lines 12a, 12b to individual wide remaining portions 13. In each laser-etched opening line 12a, 12b, pluralities of laser-etched openings 12 are arranged such that at least part of adjacent laser-etched openings are separated, so that there remains a narrow bridge-like remaining portion 14 between separated adjacent laser-etched openings 12 of the thin metal film 11. Accordingly, portions of the thin metal film remaining after forming the laser-etched openings 12, which are called remaining thin metal film portions, are composed of wide remaining portions 13 and narrow bridge-like remaining portions 14.

In both laser-etched opening lines 12a, 12b, at least part of adjacent laser-etched openings 12 are preferably separated. The widths W of the bridge-like remaining portions 14 are 20 $\mu$m or less, preferably 1 to 15 $\mu$m. Accordingly, the maximum width Wmax of the bridge-like remaining portions 14 is 20 $\mu$m, preferably 15 $\mu$m. The average width Wav of the bridge-like remaining portions 14 is 2 to 15 $\mu$m, preferably 3 to 10 $\mu$m.

In order that the bridge-like remaining portions 14 have different widths W, the thin metal film 11 may be irradiated with laser beam spots at different intervals.

Though a laser beam spot itself is circular, a region of the thin metal film evaporated by a laser beam spot is not completely circular but tends to have a slightly irregular contour due to interference between adjacent laser-etched openings 12. For example, when adjacent laser-etched openings 12 are not separated, both laser-etched openings 12, 12 are likely merged, or bridge-like remaining portions 14 likely have too small a width. This appears to be due to the fact that the evaporated metal is solidified between adjacent laser beam spots, resulting in bridge-like remaining portions 14 which are too narrow. Because laser-etched openings 12 actually formed by evaporating the thin metal film 11 do not have the same interval, even though laser beam spots are arranged with the same interval, bridge-like remaining portions 14 tend to have different widths W within a range of 20 $\mu$m or less. Accordingly, the near-field electromagnetic wave absorbing film 1 of the present invention has excellent electromagnetic wave absorbability in a wide frequency range.

The laser-etched opening lines 12a, 12b extending in two directions cross at an angle θ of 45 to 90°. This provides high electromagnetic wave absorbability with reduced anisotropy. When the crossing angle θ is less than 45°, sufficient electromagnetic wave absorbability cannot be exhibited. When the crossing angle θ is 90°, the maximum electromagnetic wave absorbability is obtained. The preferred crossing angle θ is 60 to 90°.

The centreline distance T between adjacent laser-etched opening lines 12a, 12b largely affects the sizes of wide remaining portions 13, which in turn affect the electrical resistance (and thus electromagnetic wave absorbability) of the near-field electromagnetic wave absorbing film 1. Accordingly, the centreline distance T between the laser-etched opening lines 12a, 12b should be set so as to obtain the desired electrical resistance. Specifically, the centreline distance T between the laser-etched opening lines 12a, 12b is preferably 100 to 400 μm, more preferably 150 to 300 μm.

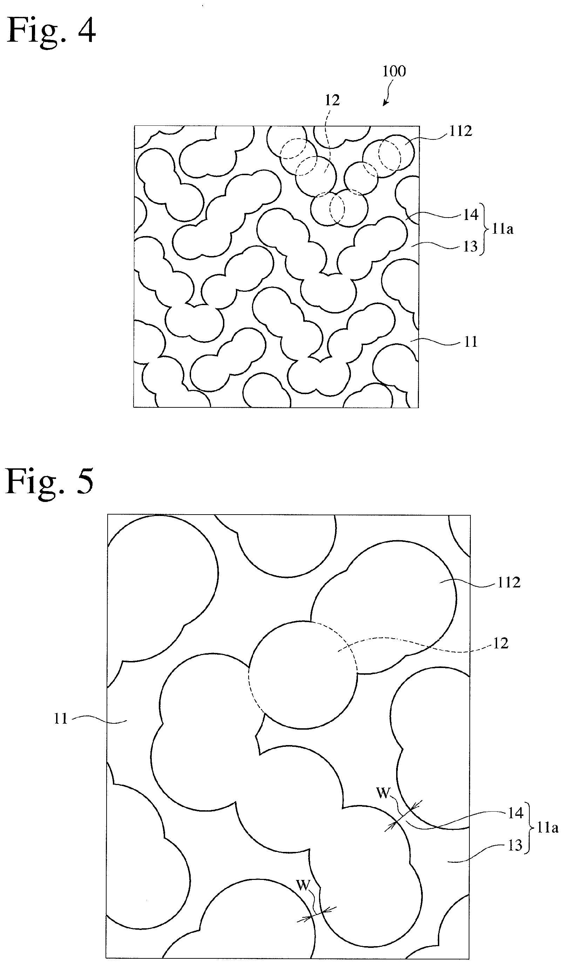

Figures 4 and 5 show a near-field electromagnetic wave absorbing film 100 according to another preferred embodiment of the present invention. This near-field electromagnetic wave absorbing film 100 has pluralities of laser-etched openings 12 which are integrally merged into elongated openings 112 (portions from which the thin metal film disappears by being evaporated). As a result, thin metal film portions remaining after forming the laser-etched openings 12 are composed of wide remaining portions 13 partitioned by the integral openings 112, and bridge-like remaining portions 14 connecting adjacent wide remaining portions 13. In this embodiment, because of relatively small wide remaining portions 13, the remaining thin metal film portions 11a composed of the wide remaining portions 13 and the bridge-like remaining portions 14 look like a network as a whole.

In this embodiment, the thin metal film 11 may be irradiated with laser beam spots at different intervals, such that part of adjacent laser-etched openings 12 are integrally connected.

The sizes of wide remaining portions 13 may vary depending on the widths W and number of bridge-like remaining portions 14, the type and thickness of the thin metal film 11 (electrical resistance), etc. In general, larger wide remaining portions 13 are obtained when the thin metal film 11 is formed by a metal having a larger electrical resistance, and when the thin metal film 11 is thinner. Intensive research has revealed that the electromagnetic wave absorbability of the near-field electromagnetic wave absorbing film 1 depends on the size and electrical resistance of thin metal film portions remaining after forming laser-etched openings 12 (remaining thin metal film portions 11a are the wide remaining portions 13 plus the bridge-like remaining portions 14). Specifically, with an electrical resistance of 50 to 300 $\Omega/100\ cm^2$ and a light transmittance, measured with laser rays having a wavelength of 660 nm, of 30 to 80%, the near-field electromagnetic wave absorbing film 1 has excellent absorbability to wide-frequency electromagnetic waves, with low anisotropy.

(4) Electrical resistance

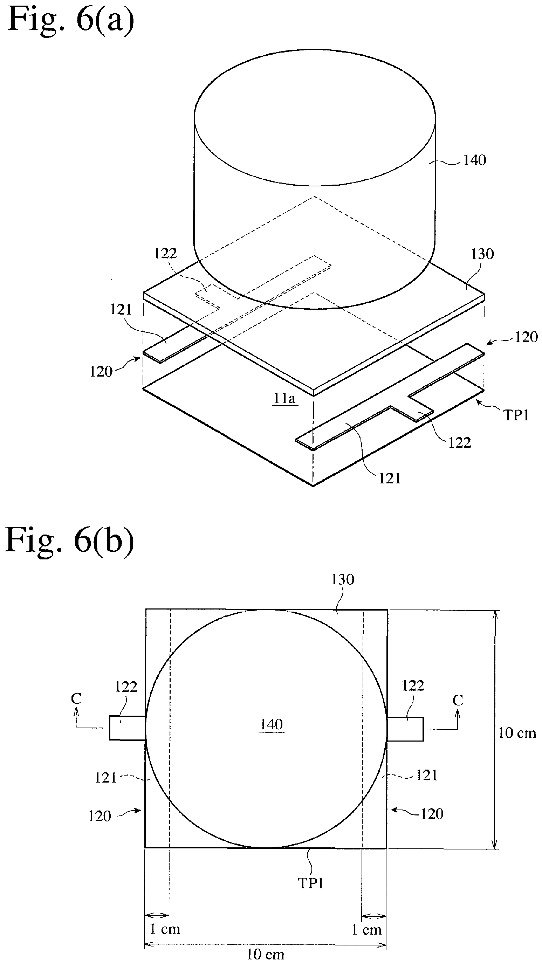

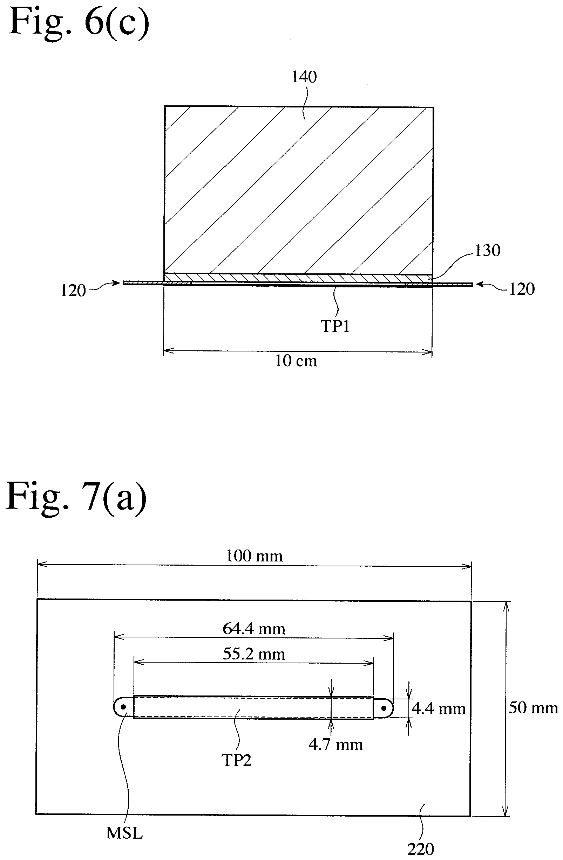

The electrical resistance of the near-field electromagnetic wave absorbing film 1 having remaining thin metal film portions 11a is measured using a DC two-terminal method under pressure (simply called "under-pressure two-terminal method"), using an apparatus shown in Figures 6(a) to 6(c). Specifically, a square test piece TP1 (10 cm × 10 cm) of the near-field electromagnetic wave absorbing film 1 is placed with its remaining thin metal film portions 11a above on a flat, hard insulation surface; and a pair of electrodes 120, 120, each comprising an electrode body portion 121 of 10 cm in length, 1 cm in width and 0.5 mm in thickness and an electrode extension 122 of 1 cm in width and 0.5 mm in thickness extending from a centre side of the electrode body portion 121, are attached to opposing side portions of the square test piece TP1. A transparent acrylic plate 130 of 10 cm × 10 cm × 5 mm is placed on the test piece TP1 and both electrodes 120, 120, such that it completely covers them, and a cylindrical weight 140 (3.85 kg) of 10 cm in diameter is placed on the transparent acrylic plate 130, in order to measure current flowing between the two electrode extensions 222, 222 in order to determine the surface resistance of the near-field electromagnetic wave absorbing film 1.

The near-field electromagnetic wave absorbing film 1 should have an electrical resistance in a range of 50 to 300 $\Omega/100\ cm^2$. When the electrical resistance is less than 50 $\Omega/100\ cm^2$ or more than 300 $\Omega/100\ cm^2$, the near-field electromagnetic wave absorbing film 1 does not have sufficient electromagnetic wave absorbability. The electrical resistance of the near-field electromagnetic wave absorbing film 1 is preferably 60 to 250 $\Omega/100\ cm^2$, more preferably 80 to 200 $\Omega/100\ cm^2$.

(5) Light transmittance

The electromagnetic wave absorbability of the near-field electromagnetic wave absorbing film 1 depends on the area ratio of the remaining thin metal film portions 11a (the wide remaining portions 13 plus the bridge-like remaining portions 14). Because the remaining thin metal film portions 11a have substantially no light transmittance, the area ratio of the remaining thin metal film portions 11a can be expressed as the light transmittance of the near-field electromagnetic wave absorbing film 1. The light transmittance of the near-field electromagnetic wave absorbing film 1 is measured with laser rays having a wavelength of 660 nm.

The light transmittance of the near-field electromagnetic wave absorbing film 1 should be in a range of 30 to 80%. When the light transmittance is less than 30%, the area ratio of the remaining thin metal film portions 11a is too large, resulting in high reflectance of electromagnetic waves and thus low electromagnetic noise absorbability. On the other hand, when the light transmittance is more than 80%, the area ratio of the remaining thin metal film portions 11a is too small, resulting in insufficient electromagnetic wave absorbability. The light transmittance of the near-field electromagnetic wave absorbing film 1 is preferably 35 to 70%.

(6) Protective layer

A protective plastic layer (not shown) is preferably formed on a thin metal film having plural lines of laser-etched openings 12 extending and crossing in two directions. A plastic film for the protective plastic layer may be the same as the plastic film 10. The thickness of the protective plastic layer is preferably about 10 to 100 $\mu$m. To prevent detachment, a plastic film is preferably heat-laminated onto the near-field electromagnetic wave absorbing film 1 as a protective layer. When the protective plastic layer is formed by a PET film, the heat lamination temperature may be 110 to 150°C.

[2] Electromagnetic wave absorbability of near-field electromagnetic wave absorbing film

(1) Transmission attenuation power ratio

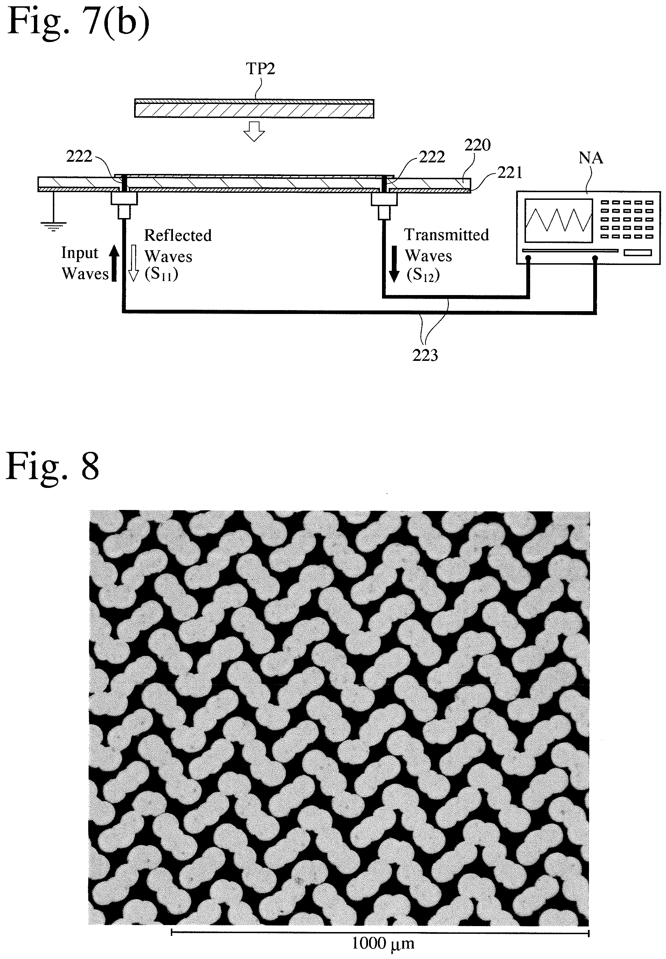

Using a system comprising a 50$\Omega$ microstrip line MSL (64.4 mm $\times$ 4.4 mm), an insulating substrate 220 supporting the microstrip line MSL, an earthed electrode 221 attached to a lower surface of the insulating substrate 220, conductive pins 222, 222 connected to both ends of the microstrip line MSL, a network analyser NA, and coaxial cables 223, 223 connecting the network analyser NAto the conductive pins 222, 222, as shown in Figures 7(a) and 7(b), a test piece TP2 of each near-field electromagnetic wave absorbing film 1 is adhered to the microstrip line MSL in order to measure its reflected wave power $S_{11}$ and transmitted wave power $S_{21}$ to an input electromagnetic wave of 0.1 to 6 GHz, thereby determining its transmission attenuation power ratio Rtp using the following formula (1):

$$Rtp = -10 \times \log[10^{S21/10}/(1-10^{S11/10})] \dots (1).$$

(2) Noise absorption ratio

In the system shown in Figures 7(a) and 7(b), the input power $P_{in}$ is the reflected wave power $S_{11}$ plus the transmitted wave power $S_{21}$ plus the absorbed power (power loss) $P_{loss}$. Accordingly, the noise absorption ratio $P_{loss}/P_{in}$ is determined by subtracting the reflected wave power $S_{11}$ and the transmitted wave power $S_{21}$ from the input power $P_{in}$, and dividing the resultant power loss $P_{loss}$ by the input power $P_{in}$.
The present invention will now be explained in more detail by referring to the Examples below, without any intention of restriction.

Example 1, and Comparative Examples 1 and 2

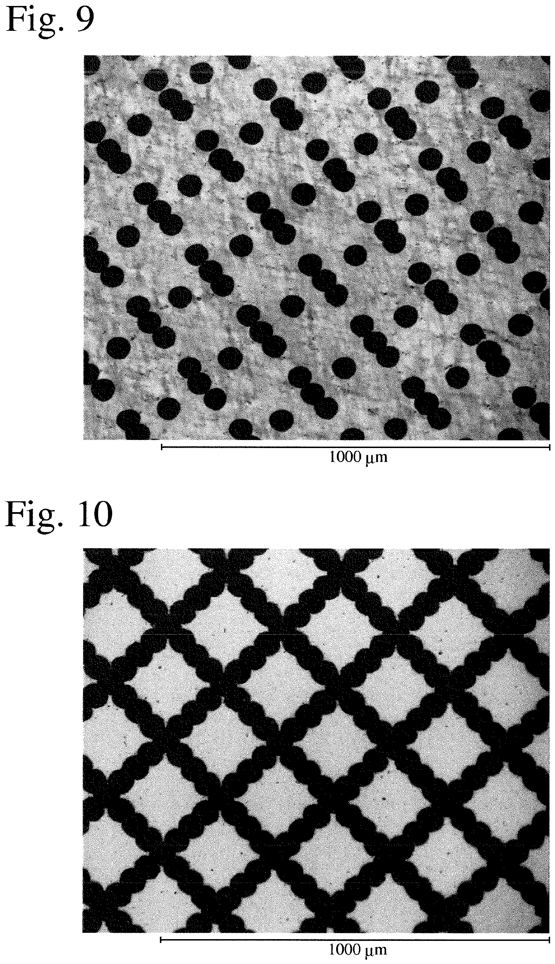

Each thin aluminium film 11 having a thickness of 80 nm was formed on a PET film 10 having a thickness of 16 $\mu$m using a vacuum vapour deposition method and provided with plural lines of laser-etched openings 12 having a diameter of 60 $\mu$m and extending and crossing in two directions by a 3-axis hybrid laser marker (MD-X1000, available from Keyence Corporation), in order to produce a near-field electromagnetic wave absorbing film 1 shown in Figures 8 to 10.
The electrical resistance of a square test piece TP1 (10 cm $\times$ 10 cm) cut out of each near-field electromagnetic wave absorbing film 1 was measured using the method described in Section [1] (4). The light transmittance of each near-field electromagnetic wave absorbing film 1 was measured with laser rays having a wavelength of 660 nm. The results are shown in Table 1.

Table 1

| No. | Example 1 | Com. Ex. 1 | Com. Ex. 2 |
|---|---|---|---|
| Corresponding Figure | Figure 8 | Figure 9 | Figure 10 |
| Crossing Angle $\theta^{(1)}$(°) | 90 | 90 | 90 |
| Maximum Width Wmax$^{(2)}$ ($\mu$m) | 15 | 60 | 0 |

(continued)

| No. | Example 1 | Com. Ex. 1 | Com. Ex. 2 |
|---|---|---|---|
| Average Width Wav[(2)] ($\mu$m) | 8 | 50 | 0 |
| Electrical Resistance ($\Omega$/100 cm$^2$) | 100 | 2 | $\infty$ |
| Light Transmittance (%) | 70 | 25 | 50 |
| Notes: (1) The crossing angle $\theta$ of laser-etched opening lines. (2) Measured in bridge-like remaining portions of the thin metal film. | | | |

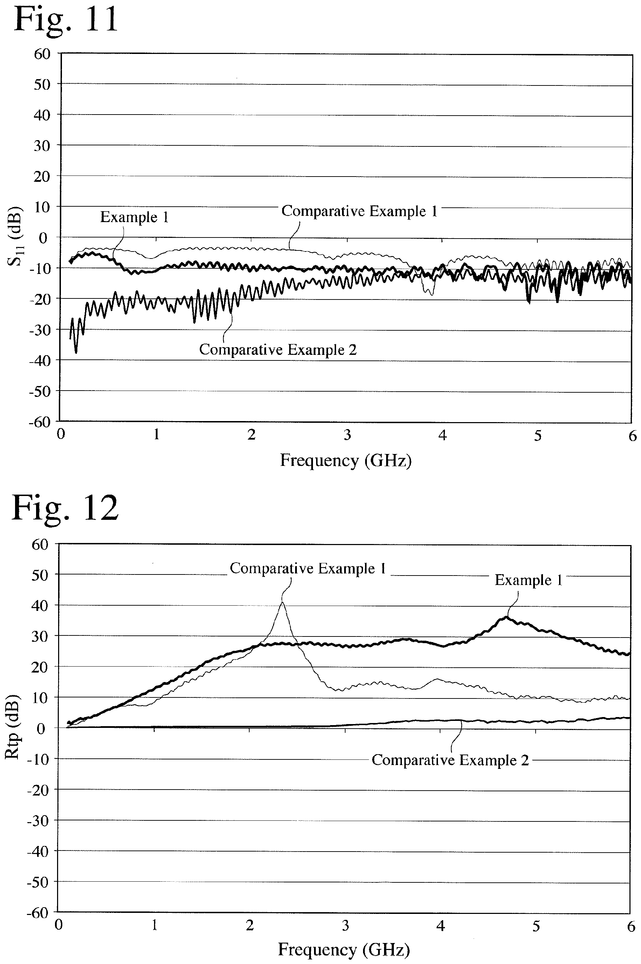

A test piece TP2 (55.2 mm $\times$ 4.7 mm) cut out of each near-field electromagnetic wave absorbing film 1 was adhered to a microstrip line MSL in the system shown in Figures 7(a) and 7(b), in order to measure the reflected wave power $S_{11}$ and transmitted wave power $S_{21}$ relative to the input power $P_{in}$ in a frequency range of 0.1 to 6 GHz. The reflected wave power $S_{11}$ and the transmitted wave power $S_{21}$ were measured using the method described in Section [2] (1) and (2), in order to determine $S_{11}$ and a transmission attenuation power ratio Rtp in a frequency range of 0.1 to 6 GHz. $S_{11}$ and the transmission attenuation power ratio Rtp in a frequency range of 0.1 to 6 GHz are shown in Figures 11 and 12, respectively. As is clear from Figure 11, too much wave power was reflected in Comparative Example 1 which had too few laser-etched openings 12 (too low an electrical resistance and light transmittance). As is clear from Figure 12, the transmission attenuation power ratio Rtp was low in Comparative Example 2 which had too many laser-etched openings 12 (too high an electrical resistance).

Example 2, and Comparative Examples 3 and 4

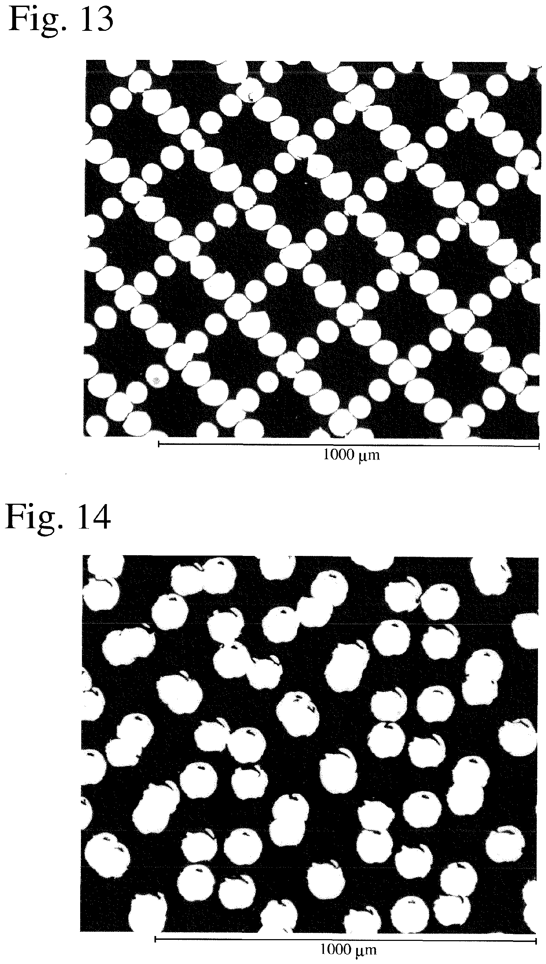

Each thin nickel film 11 having a thickness of 50 nm was formed on a PET film 10 having a thickness of 16 $\mu$m using a vacuum vapour deposition method and provided with plural lines of laser-etched openings 12 having a diameter of 60 $\mu$m and extending and crossing in two directions by a 3-axis hybrid laser marker (MD-X1000, available from Keyence Corporation), in order to produce a near-field electromagnetic wave absorbing film 1 as shown in Figures 13 to 15. The electrical resistance and light transmittance of each near-field electromagnetic wave absorbing film 1 was measured using the same methods as in Example 1. The results are shown in Table 2.

Table 2

| No. | Example 2 | Com. Ex. 3 | Com. Ex. 4 |
|---|---|---|---|
| Corresponding Figure | Figure 13 | Figure 14 | Figure 15 |
| Crossing Angle $\theta$ [(1)] ($°$) | 90 | 90 | 90 |
| Maximum Width Wmax[(2)] ($\mu$m) | 15 | 60 | 0 |
| Average Width Wav[(2)] ($\mu$m) | 7 | 50 | 0 |
| Electrical Resistance ($\Omega$/100 cm$^2$) | 60 | 6 | $\infty$ |
| Light Transmittance (%) | 40 | 30 | 50 |
| Notes: (1) The crossing angle $\theta$ of laser-etched opening lines. (2) Measured in bridge-like remaining portions of the thin metal film. | | | |

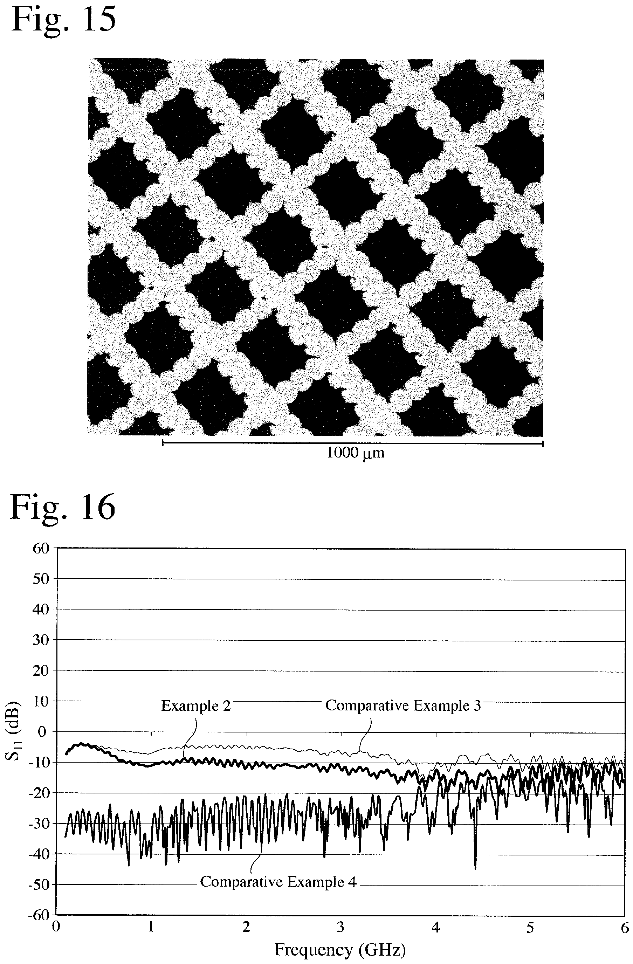

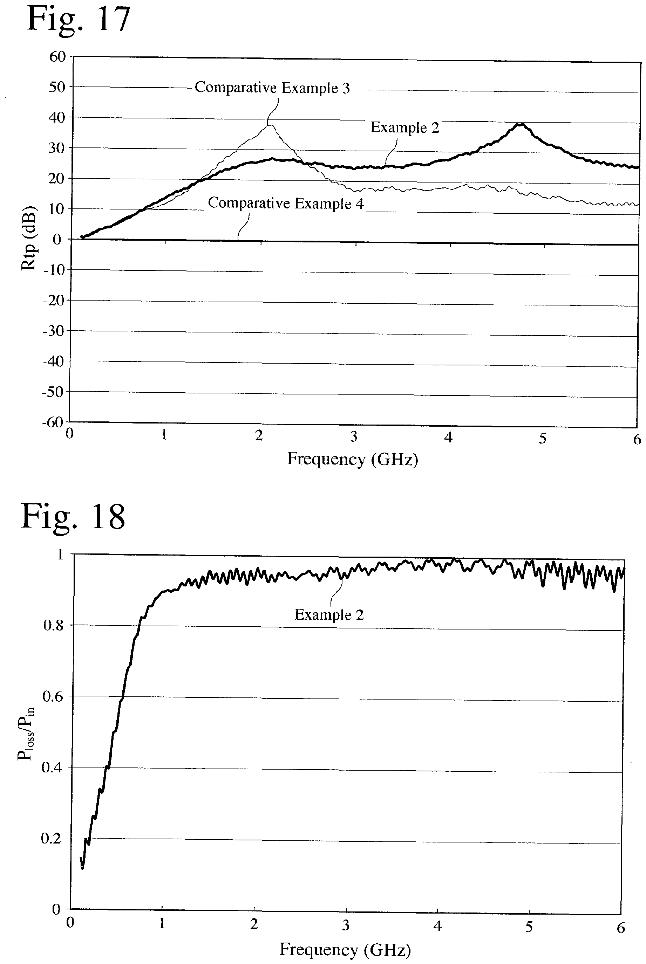

$S_{11}$, the transmission attenuation power ratio Rtp and the noise absorption ratio $P_{loss}/P_{in}$ of each near-field electromagnetic wave absorbing film 1 in a frequency range of 0.1 to 6 GHz were measured using the same methods as in Example 1. $S_{11}$ and the transmission attenuation power ratio Rtp in a frequency range of 0.1 to 6 GHz are shown in Figures 16 and 17, respectively. The noise absorption ratio $P_{loss}/P_{in}$ of Example 2 is shown in Figure 18. As is clear from Figure 16, too much wave power was reflected in Comparative Example 3 which had too few laser-etched openings 12 (too low an electrical resistance and light transmittance). As is clear from Figure 17, the transmission attenuation power ratio Rtp was low in Comparative Example 4 which had too many laser-etched openings 12 (too high an electrical resistance). Furthermore, as is clear from Figure 18, the electrical resistance and light transmittance in Example 2, which meets the requirements of the present invention with respect to laser-etched openings 12, exhibited a high noise absorption ratio $P_{loss}/P_{in}$.

EFFECTS OF THE INVENTION

The near-field electromagnetic wave absorbing film of the present invention has excellent electromagnetic wave absorbability with small anisotropy, because laser-etched opening lines are formed in two directions in a thin metal film, pluralities of laser-etched openings being arranged in each line such that at least part of adjacent laser-etched openings are separated, thin metal film portions remaining after forming the laser-etched openings being composed of wide remaining portions partitioned by the laser-etched opening lines and narrow bridge-like remaining portions connecting the wide remaining portions, so that it has an electrical resistance of 50 to 300 $\Omega$/100 cm$^2$ and a light transmittance, measured with laser rays having a wavelength of 660 nm, of 30 to 80%. The near-field electromagnetic wave absorbing film of the present invention having such features is suitably usable as a noise suppression sheet for communications apparatus such as mobile phones, smartphones, wireless LAN, etc., and electronic appliances such as computers, etc.

DESCRIPTION OF REFERENCE NUMERALS

| | |
|---|---|
| 1: | near-field electromagnetic wave absorbing film |
| 10: | plastic film |
| 11: | thin metal film |
| 11a: | remaining thin metal film portion |
| 12: | laser-etched opening |
| 0088] 12a, 12b: | laser-etched opening line |
| 13: | wide remaining portion |
| 14: | bridge-like remaining portion |
| 112: | integral opening |
| 120: | electrode |
| 121: | electrode body portion |
| 122: | electrode extension |
| 130: | transparent acrylic plate |
| 140: | cylindrical weight |
| 220: | insulating substrate |
| 221: | earthed electrode |
| 222: | conductive pin |
| 223: | coaxial cable |
| D: | diameter of laser-etched opening |
| W: | width of bridge-like remaining portion |
| T: | centreline distance between adjacent laser-etched opening lines |
| TP1, TP2: | test piece of near-field electromagnetic wave absorbing film |
| MSL: | microstrip line |
| NA: | network analyser |

**Claims**

1.  A near-field electromagnetic wave absorbing film comprising a plastic film (10), and a single- or multi-layered thin metal film (11) formed on a surface of the plastic film (10), wherein:

    said thin metal film (11) is provided with plural lines of openings (12) extending and crossing in two directions; pluralities of said openings (12) are arranged in each line such that at least part of adjacent openings (12) are separated;
    said opening lines (12a, 12b) extend in two directions crossing at an angle of 45 to 90°;
    thin metal film portions, remaining after forming said openings (12), are composed of wide remaining portions (13) partitioned by said opening lines (12a, 12b), and bridge-like remaining portions (14) connecting adjacent wide remaining portions (13); and
    said bridge-like remaining portions (14) have widths of 20 $\mu$m or less; **characterised in that** the openings (12) are laser-etched,
    wherein said near-field electromagnetic wave absorbing film has an electrical resistance of 50 to 300 $\Omega$/100 cm$^2$ and a light transmittance, measured with laser rays having a wavelength of 660 nm, of 30 to 80%.

**2.** The near-field electromagnetic wave absorbing film according to Claim 1, wherein said bridge-like remaining portions (14) have an average width of 2 to 15 $\mu$m.

**3.** The near-field electromagnetic wave absorbing film according to Claim 1 or Claim 2, wherein the crossing angle ($\theta$) of said laser-etched opening lines (12a, 12b) is 45 to 90°.

**4.** The near-field electromagnetic wave absorbing film according to any one of Claims 1 to 3, wherein said laser-etched openings (12) have diameters of 100 $\mu$m or less.

**5.** The near-field electromagnetic wave absorbing film according to any one of Claims 1 to 4, wherein the centreline distance (T) between adjacent laser-etched opening lines (12a, 12b) is 1.5 to 5 times the diameters of said laser-etched openings (12).

**6.** The near-field electromagnetic wave absorbing film according to any one of Claims 1 to 5, wherein the thickness of said thin metal film (11) is 10 to 300 nm.

**7.** The near-field electromagnetic wave absorbing film according to any one of Claims 1 to 6, wherein said thin metal film (11) is made of at least one metal selected from the group consisting of aluminium, copper, silver, tin, nickel, cobalt, chromium and alloys thereof.

## Patentansprüche

**1.** Absorbierende Folie für elektromagnetische Nahfeldwellen, umfassend eine Kunststofffolie (10) und einen dünnen einschichtigen oder mehrschichtigen Metallfilm (11), gebildet auf einer Oberfläche der Kunststofffolie (10), wobei:

der dünne Metallfilm (11) mit einer Vielzahl von Öffnungslinien (12), die sich in zwei Richtungen erstrecken und kreuzen, versehen ist;
Vielzahlen von den Öffnungen (12) in jeder Linie angeordnet sind, so dass benachbarte Öffnungen (12) wenigstens teilweise getrennt sind;
sich die Öffnungslinien (12a, 12b) in zwei Richtungen, welche sich in einem Winkel von 45 bis 90° kreuzen, erstrecken;
dünner Metallfilm-Anteile, die nach dem Bilden der Öffnungen (12) verbleiben, aus breiten verbleibenden Anteilen (13), aufgeteilt durch die Öffnungslinien (12a, 12b), und brückenähnlichen verbleibenden Anteilen (14), die benachbarte breite verbleibende Anteile (13) verbinden, bestehen; und
die brückenähnlichen verbleibenden Anteile (14) Breiten von 20 $\mu$m oder weniger aufweisen;
**dadurch gekennzeichnet, dass** die Öffnungen (12) gelasert sind,
wobei die absorbierende Folie für elektromagnetische Nahfeldwellen einen elektrischen Widerstand von 50 bis 300 $\Omega$/100 cm$^2$ und eine Lichtdurchlässigkeit, gemessen mit Laserstrahlen mit einer Wellenlänge von 660 nm, von 30 bis 80 % aufweist.

**2.** Absorbierende Folie für elektromagnetische Nahfeldwellen gemäß Anspruch 1, wobei die brückenähnlichen verbleibenden Anteile (14) eine mittlere Breite von 2 bis 15 $\mu$m aufweisen.

**3.** Absorbierende Folie für elektromagnetische Nahfeldwellen gemäß Anspruch 1 oder Anspruch 2, wobei der Kreuzungswinkel ($\theta$) der gelaserten Öffnungslinien (12a, 12b) 45 bis 90° ist.

**4.** Absorbierende Folie für elektromagnetische Nahfeldwellen gemäß einem der Ansprüche 1 bis 3, wobei die gelaserten Öffnungen (12) Durchmesser von 100 $\mu$m oder weniger aufweisen.

**5.** Absorbierende Folie für elektromagnetische Nahfeldwellen gemäß einem der Ansprüche 1 bis 4, wobei der Mittellinienabstand (T) zwischen benachbarten gelaserten Öffnungslinien (12a, 12b) dem 1,5- bis 5-fachen der Durchmesser der gelaserten Öffnungen (12) entspricht.

**6.** Absorbierende Folie für elektromagnetische Nahfeldwellen gemäß einem der Ansprüche 1 bis 5, wobei die Dicke des dünnen Metallfilms (11) 10 bis 300 nm beträgt.

**7.** Absorbierende Folie für elektromagnetische Nahfeldwellen gemäß einem der Ansprüche 1 bis 6, wobei der dünne Metallfilm (11) aus mindestens einem Metall, welches aus der Gruppe ausgewählt ist, die aus Aluminium, Kupfer, Silber, Zinn, Nickel, Cobalt, Chrom und Legierungen davon besteht, hergestellt ist.

**Revendications**

1. Film d'absorption d'ondes électromagnétiques de champ proche, comprenant un film de matière plastique (10), et un film métallique mince monocouche ou multicouche (11) formé sur une surface du film de matière plastique (10), dans lequel :

   ledit film métallique mince (11) est muni de plusieurs lignes d'ouvertures (12) s'étendant et se croisant dans deux directions ;
   des pluralités desdites ouvertures (12) sont agencées dans chaque ligne de telle sorte qu'au moins une partie d'ouvertures adjacentes (12) soient séparées ;
   lesdites lignes d'ouvertures (12a, 12b) s'étendent dans deux directions se croisant selon un angle compris entre 45 et 90° ;
   des parties de film métallique mince, restant après la formation desdites ouvertures (12), sont constituées par des parties restantes larges (13) séparées par lesdites lignes d'ouvertures (12a, 12b), et des parties restantes en forme de pont (14) reliant des parties restantes larges adjacentes (13) ; et
   lesdites parties restantes en forme de pont (14) ont des largeurs inférieures ou égales 20 $\mu$m;
   **caractérisé en ce que** les ouvertures (12) sont gravées au laser,
   dans lequel ledit film d'absorption d'ondes électromagnétiques de champ proche a une résistance électrique comprise entre 50 et 300 $\Omega$/100 cm$^2$ et un facteur de transmission de la lumière, mesuré avec des rayons laser ayant une longueur d'onde de 660 nm, compris entre 30 et 80%.

2. Film d'absorption d'ondes électromagnétiques de champ proche selon la revendication 1, dans lequel lesdites parties restantes en forme de pont (14) ont une largeur moyenne comprise entre 2 et 15 $\mu$m.

3. Film d'absorption d'ondes électromagnétiques de champ proche selon la revendication 1 ou la revendication 2, dans lequel l'angle de croisement ($\theta$) desdites lignes d'ouvertures gravées au laser (12a, 12b) est compris entre 45 et 90°.

4. Film d'absorption d'ondes électromagnétiques de champ proche selon l'une quelconque des revendications 1 à 3, dans lequel lesdites ouvertures gravées au laser (12) ont des diamètres inférieurs ou égaux à 100 $\mu$m.

5. Film d'absorption d'ondes électromagnétiques de champ proche selon l'une quelconque des revendications 1 à 4, dans lequel la distance de lignes centrales (T) entre des lignes d'ouvertures gravées au laser adjacentes (12a, 12b) est comprise entre 1,5 et 5 fois les diamètres desdites ouvertures gravées au laser (12).

6. Film d'absorption d'ondes électromagnétiques de champ proche selon l'une quelconque des revendications 1 à 5, dans lequel l'épaisseur dudit film métallique mince (11) est comprise entre 10 et 300 nm.

7. Film d'absorption d'ondes électromagnétiques de champ proche selon l'une quelconque des revendications 1 à 6, dans lequel ledit film métallique mince (11) est constitué par au moins un métal sélectionné parmi le groupe comprenant l'aluminium, le cuivre, l'argent, l'étain, le nickel, le cobalt, le chrome et des alliages de ceux-ci.

## Fig. 1

## Fig. 2(a)

## Fig. 2(b)

Fig. 3

# Fig. 4

# Fig. 5

Fig. 6(a)

Fig. 6(b)

# Fig. 6(c)

140

130

120 → ← 120

TP1

10 cm

# Fig. 7(a)

100 mm

64.4 mm

55.2 mm

4.4 mm

4.7 mm

TP2

50 mm

MSL

220

## Fig. 7(b)

## Fig. 8

1000 μm

Fig. 9

1000 μm

Fig. 10

1000 μm

## Fig. 11

## Fig. 12

Fig. 13

1000 μm

Fig. 14

1000 μm

## Fig. 15

1000 μm

## Fig. 16

Frequency (GHz)

## Fig. 17

## Fig. 18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9148782 A
- WO 2010093027 A
- EP 1993338 A1
- WO 2014148589 A1